# EUROPÄISCHE PATENTANMELDUNG

(11) **EP 4 730 605 A1**
(43) Veröffentlichungstag der Anmeldung: **22.04.2026**
(21) Anmeldenummer: 25199004.0
(22) Anmeldetag: 29.08.2025
(51) Int. Cl.: H02J 7/65, H02M 1/32

(54) **ROHRLEITUNGSSYSTEM, VERWENDUNG EINES ROHRLEITUNGSSYSTEMS UND ELEKTRISCHES GERÄT**

(30) Priorität: 17.09.2024 DE 102024208857
(71) Anmelder: Siemens Energy Global GmbH & Co. KG, 81739 München (DE)
(72) Erfinder: Kalb, Stefan, 90480 Nürnberg (DE); Hüttner, Sebastian, 90768 Fürth (DE)

(57) **Zusammenfassung**

Die Erfindung betrifft ein Rohrleitungssystem (1), insbesondere zum Kühlen eines elektrischen Geräts, bevorzugt zum Kühlen eines Umrichters, mit mindestens zwei, insbesondere einer Vielzahl von Rohrleitungssegmenten (4, 5, 6), wobei die Rohrleitungssegmente (4, 5, 6) aus PVC, insbesondere aus chloriertem PVC bestehen, und wobei die Rohrleitungssegmente (4, 5, 6) stoffschlüssig miteinander verbunden sind.

## Beschreibung

Die vorliegende Erfindung betrifft ein Rohrleitungssystem, die Verwendung eines Rohrleitungssystems und ein elektrisches Gerät mit einem solchen Rohrleitungssystem.

Elektrische Geräte, welche hohe Leistungen umsetzen, benötigen häufig ein Kühlsystem. Dieses kann als Flüssigkeitskühlung ausgebildet sein. Beispiele für solche elektrischen Geräte liegen im Bereich der Hochspannungsgleichstromübertragungstechnik. Hierbei kann es sich um Umrichter handeln, bei denen hohe Verlustleitungen auftreten können.

Für das Kühlsystem, welches Wasser oder ein Wasser-Glykol-Gemisch verwenden kann, werden im Stand der Technik Rohrleitungssysteme verwendet. Diese können geradlinige Rohrleitungssegmente (Rohre), Rohrbögen, Abzweigstücke und dergleichen beinhalten. Ein solches Rohrleitungssystem ist im elektrischen Gerät verlegt. Neben dem reinen Flüssigkeitstransport muss ein solches Rohrleitungssystem auch eine elektrische Potentialtrennung gewährleisten. Insbesondere in Hochspannungsumrichtern können sich dabei unterschiedliche Potentiale im Bereich von bis zu 1000 kV ergeben.

Daneben muss das Material, aus dem das Rohrleitungssystem besteht, elektrisch isolierend und schwer entflammbar sein. Die im Betrieb auftretenden Drücke und Temperaturen, welche bis zu 6 bar bzw. bis zu 100 °C erreichen können, muss das Rohrleitungssystem über eine Lebensdauer von mehr als 30 Jahren aushalten können.

Zumeist werden für diesen Zweck Rohrleitungssysteme aus Fluorpolymeren eingesetzt. Diese weisen die entsprechenden Eigenschaften auf. Allerdings stehen einige Fluorverbindungen im Verdacht, negative Auswirkungen auf die Umwelt zu haben. Aus diesem Grund gibt es Bestrebungen, bestimmte Fluorverbindungen zu verbieten.

Vor diesem Hintergrund besteht die Aufgabe der Erfindung darin, ein alternatives Rohrleitungssystem insbesondere zur Kühlung eines elektrischen Geräts bereitzustellen, welches bevorzugt die zuvor genannten Nachteile vermeidet und im Hinblick auf die Umwelt unbedenklich ist.

Diese Aufgabe ist gelöst durch ein Rohrleitungssystem, insbesondere zum Kühlen eines elektrischen Geräts, bevorzugt zum Kühlen eines Umrichters, mit mindestens zwei, insbesondere einer Vielzahl von Rohrleitungssegmenten, wobei die Rohrleitungssegmente aus PVC, insbesondere aus chloriertem PVC (PVC-C) bestehen, und wobei die Rohrleitungssegmente stoffschlüssig miteinander verbunden sind.

Der Erfindung liegt die grundsätzliche Überlegung zugrunde, kein Fluorpolymer, sondern Polyvinylchlorid (PVC) als Werkstoff für das Rohrleitungssystem zu verwenden. Bevorzugt wird PVC-C, das heißt chloriertes und/oder nachchloriertes Polyvinylchlorid verwendet. Der Chlorgehalt des PVC-C kann mindestens 40 %, insbesondere mindestens 60 %, bevorzugt mindestens 67 %, und/oder höchstens 90 %, insbesondere höchstens 80 %, bevorzugt höchstens 74 % betragen. Chloriertes PVC zeichnet sich durch eine gute thermische und chemische Beständigkeit aus. Ferner enthält chloriertes PVC bevorzugt keinen Weichmacher und ist damit auch im Hinblick auf die Umweltauswirkungen und bedenklich. Außerdem zeichnet sich PVC, insbesondere chloriertes PVC, durch eine gute Verfügbarkeit und günstige dielektrische bzw. isolierende Eigenschaften aus.

Das PVC, insbesondere das chlorierte PVC, kann mit Stabilisatoren versehen sein. Insbesondere können die Rohrleitungssegmente UV-Stabilisatoren aufweisen, wodurch ein Zerfall beispielsweise unter dem Einfluss von Sonnenlicht verzögert werden kann.

Die Rohrleitungssegmente können geradlinige Rohrleitungssegmente, Rohrbögen, Abzweigstücke und/oder Verschlussstücke sein oder umfassen. Die Rohrleitungssegmente können Absperreinrichtungen und/oder Ventileinrichtungen umfassen. Mit anderen Worten kann ein Rohrleitungssystem aus einer Vielzahl verschiedener Rohrleitungssegmente zusammengesetzt werden bzw. sein. Die geradlinigen Rohrleitungssegmente können in einer entsprechenden Länge bereitgestellt werden und beispielsweise an ihren Stirnseiten mit entsprechenden weiteren Rohrleitungssegmenten, beispielsweise Rohrbögen, Abzweigstücken oder anderen geradlinigen Rohrleitungssegmenten etc. verbunden werden bzw. sein.

Zur Steuerung der Durchflussmenge insbesondere eines Kühlmittels, welches Wasser und/oder ein Wasser-Glykol-Gemisch aufweisen oder daraus bestehen kann, können Absperreinrichtungen und/oder Ventileinrichtungen vorgesehen sein. Diese können derart ausgestaltet sein, dass ein freier Durchgangsquerschnitt variiert werden kann, um die Durchflussmenge einzustellen.

In weiterer Ausgestaltung können die Rohrleitungssegmente des erfindungsgemäßen Rohrleitungssystems durch thermische Fügeverbindungen miteinander verbunden sein. In konkreter Ausgestaltung kann es sich hier um Schweißverbindungen handeln, insbesondere um Stumpfschweißverbindungen. Das bedeutet, dass die Rohrleitungssegmente bevorzugt nicht miteinander verklebt sind, sondern durch ein thermisches Fügeverfahren insbesondere umlaufend miteinander verbunden sind. Eine solche Ausgestaltung zeichnet sich insbesondere durch eine lange Lebensdauer und eine zuverlässige Dichtheit bei gleichzeitig hoher mechanischer und thermischer Beanspruchbarkeit aus.

Konkret können die Rohrleitungssegmente mittels Heizelement-Stumpfschweißen und/oder mittels Infrarot-Schweißen miteinander verbunden sein. Anders ausgedrückt, können die Rohrleitungssegmente mittels Heizelement-Stumpfschweißverbindungen und/oder mittels Infrarot-Schweißverbindungen, insbesondere Stumpfschweißverbindungen, miteinander verbunden sein.

Ein Verfahren zur Herstellung des Rohrleitungssystems kann das Bereitstellen der miteinander zu verbindenden Rohrleitungssegmente und das anschließende, formschlüssige Verbinden, insbesondere mittels eines thermischen Fügeverfahrens, bevorzugt mittels eines Schweißverfahrens, besonders bevorzugt mittels eines Stumpfschweißverfahrens umfassen.

Beim Heizelement-Stumpfschweißen wird bevorzugt zwischen den Fügeflächen, das heißt zwischen den Stirnseiten der Rohrleitungssegmente, die miteinander verbunden werden sollen, ein Heizelement positioniert, welches die beiden Rohrleitungssegmente im Bereich ihrer Fügeflächen aufheizt. Nach dem Erreichen einer bestimmten Temperatur und/oder einer bestimmten Aufheizdauer wird das Heizelement von den Fügeflächen gelöst und die beiden Rohrleitungssegmente mit einem definierten Fügedruck aneinander gedrückt. Bevorzugt bleiben die beiden Rohrleitungssegmente, die miteinander verbunden werden sollen, bis zur vollständigen Abkühlung unter Einfluss des Fügedrucks. Zur Herstellung einer Infrarot-Schweißverbindung wird die Wärme im Bereich der Fügeflächen durch Infrarot-Strahlung eingebracht.

Denkbar ist auch, dass die Rohrleitungssegmente durch Warmgasschweißverbindungen miteinander verbunden sind. In diesem Fall werden die beiden zu verbindenden Rohrleitungssegmente durch eine Gasflamme aufgeheizt. Denkbar sind prinzipiell auch Reibschweißverbindungen, bei dem die miteinander zu verbindenden Rohrleitungssegmente relativ zueinander bewegt werden, wobei sie mit ihren Fügeflächen aneinander anliegen bzw. gegeneinander gedrückt werden. Durch die Relativbewegung und die damit einhergehende Reibung wird eine entsprechende Wärme erzeugt. Sobald der Bereich um die Fügeflächen herum eine bestimmte Temperatur erreicht hat, werden dann die beiden zu verbindenden Rohrleitungssegmente unter einem Fügedruck aneinander gedrückt, so dass eine stoffschlüssige Verbindung entsteht.

Das Rohrleitungssystem muss nicht zwingend nur aus Rohrleitungssegmenten aus PVC, insbesondere chloriertem PVC, bestehen. Einzelne Abschnitte können auch Rohrleitungssegmente aus anderen Materialien aufweisen. Beispielsweise können einzelne Abschnitte metallische Rohrleitungssegmente aufweisen, die über geeignete Verbindungen miteinander und mit benachbarten Rohrleitungssegmenten aus PVC verbunden sind.

Das Rohrleitungssystem kann an einer Trägerstruktur befestigt sein oder Befestigungsmittel aufweisen, um es an einer Trägerstruktur zu befestigen.

Das Rohrleitungssystem kann auch Schlauchleitungssegmente umfassen. Diese können beispielsweise als Zulaufleitung oder als Ablaufleitung dienen. Möglich ist auch, dass Schlauchleitungssegmente als Kompensatoren vorgesehen sind. Die Schlauchleitungssegmente können metallische Schläuche, beispielsweise Edelstahlwellschläuche, und/oder Kunststoffschläuche, insbesondere mit metallischen Einlagen, enthalten.

Die der Erfindung zugrundeliegende Aufgabe ist ferner gelöst durch die Verwendung eines Rohrleitungssystems, insbesondere wie zuvor beschrieben, zur Kühlung eines elektrischen Geräts, insbesondere zum Kühlen eines Umrichters, bevorzugt zum Kühlen eines FACTS-Umrichters und/oder eines HGÜ-Umrichters. Derartige Umrichter können dadurch gekennzeichnet sein, dass im Betrieb hohe Verlustleistungen auftreten und dementsprechend ein hoher Kühlbedarf erforderlich ist. Ein HGÜ-Umrichter wird dabei bevorzugt zur Hochspannungs-Gleichstrom-Übertragung verwendet. Insbesondere kann ein solcher Umrichter je nach Bedarf Drehstrom in Gleichstrom und/oder Gleichstrom in Drehstrom umwandeln. Ein FACTS-Umrichter kann insbesondere in flexiblen Drehstromübertragungssystemen (flexible AC transmission systems) eingesetzt werden.

Ferner ist die der Erfindung zugrundeliegende Aufgabe gelöst durch ein elektrisches Gerät, insbesondere einen Umrichter, bevorzugt einen FACTS-Umrichter und/oder einen HGÜ-Umrichter, mit einem Rohrleitungssystem wie zuvor beschrieben.

Für die weitere Ausgestaltung der Erfindung wird auf die Unteransprüche und auf die nachstehende Beschreibung eines Ausführungsbeispiels unter Bezugnahme auf die Zeichnung verwiesen. In der Zeichnung zeigt:

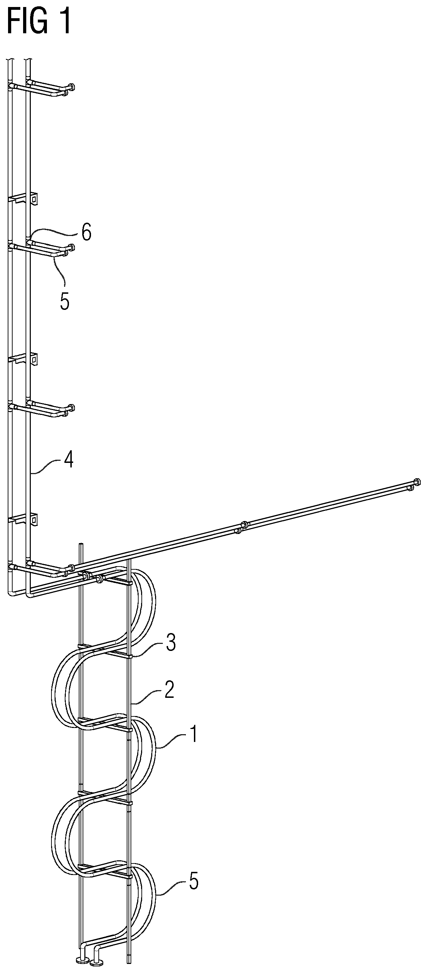

Figur 1 ein Rohrleitungssystem zur Kühlung eines elektrischen Geräts gemäß der vorliegenden Erfindung in einer schematischen perspektivischen Darstellung.

Die Figur 1 zeigt ein Rohrleitungssystem 1 zur Kühlung eines HGÜ-Umrichters. Dieses ist an einer Trägerstruktur 2 befestigt, die mehrere Trägerprofile 3 aufweist.

Das Rohrleitungssystem 1 umfasst eine Vielzahl von Rohrleitungssegmenten. Diese umfassen beispielhaft geradlinige Rohrleitungssegmente 4, Rohrbögen 5 und Abzweigstücke 6, die verschiedene Nennweiten aufweisen können.

Die verschiedenen Rohrleitungssegmente 4, 5, 6 bestehen aus chloriertem PVC und sind durch Heizelement-Stumpfschweißverbindungen miteinander verbunden.

Dadurch, dass die Rohrleitungssegmente aus PVC-C, das heißt chloriertem PVC, bestehen, besitzt das Rohrleitungssystem eine gute chemische und thermische Beständigkeit und hat darüber hinaus günstige isolationstechnische bzw. dielektrische Eigenschaften. Gleichzeitig ist PVC-C ein kostengünstiges und in hohem Maße verfügbares Material.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Rohrleitungssystem (1), insbesondere zum Kühlen eines elektrischen Geräts, bevorzugt zum Kühlen eines Umrichters, mit mindestens zwei, insbesondere einer Vielzahl von Rohrleitungssegmenten (4, 5, 6), wobei die Rohrleitungssegmente (4, 5, 6) aus PVC, insbesondere aus chloriertem PVC bestehen, und wobei die Rohrleitungssegmente (4, 5, 6) stoffschlüssig miteinander verbunden sind.

2. Rohrleitungssystem (1) nach Anspruch 1, **dadurch gekennzeichnet, dass** die Rohrleitungssegmente geradlinige Rohrleitungssegmente (4), Rohrbögen (5), Abzweigstücke (6), Verschlussstücke sind oder umfassen, und/oder dass die Rohrleitungssegmente Absperreinrichtungen und/oder Ventileinrichtungen umfassen.

3. Rohrleitungssystem (1) nach Anspruch 1 oder 2, **dadurch gekennzeichnet, dass** die Rohrleitungssegmente (4, 5, 6) durch thermische Fügeverbindungen miteinander verbunden sind.

4. Rohrleitungssystem (1) nach Anspruch 3, **dadurch gekennzeichnet, dass** die Rohrleitungssegmente (4, 5, 6) durch Schweißverbindungen, insbesondere durch Stumpfschweißverbindungen, miteinander verbunden sind.

5. Rohrleitungssystem (1) nach Anspruch 3 oder 4, **dadurch gekennzeichnet, dass** die Rohrleitungssegmente (4, 5, 6) mittels Heizelement-Stumpfschweißen und/oder mittels Infrarot-Schweißen miteinander verbunden sind.

6. Verwendung eines Rohrleitungssystems (1) nach einem der Ansprüche 1 bis 5 zur Kühlung eines elektrischen Geräts, insbesondere zum Kühlen eines Umrichters, bevorzugt zum Kühlen eines FACTS-Umrichters und/oder eines HGÜ-Umrichters.

7. Elektrisches Gerät, insbesondere Umrichter, bevorzugt FACTS-Umrichter und/oder HGÜ-Umrichter, mit einem Rohrleitungssystem (1) nach einem der Ansprüche 1 bis 6.
